# EUROPÄISCHE PATENTSCHRIFT

(11) **EP 0 478 962 B1**
(45) Veröffentlichungstag und Bekanntmachung des Hinweises auf die Patenterteilung: **26.10.1994**
(21) Anmeldenummer: 91114671.0
(22) Anmeldetag: 30.08.1991
(51) Int. Cl.: H05K 3/46, H05K 1/00, H01P 3/08, H01P 1/203

(54) **Mikrowellen-Streifen-Leitungsanordnung**
Microwave-stripline assembly
Assemblage de conducteurs à bande pour micro-ondes

(30) Priorität: 05.10.1990 DE 4031536
(43) Veröffentlichungstag der Anmeldung: 08.04.1992
(73) Patentinhaber: Rohde & Schwarz GmbH & Co. KG, D-81671 München (DE)
(72) Erfinder: Szpilok, Waldemar, Dipl.-Ing., W-8156 Otterfing (DE)
(74) Vertreter: Graf, Walter, Dipl.-Ing.

(56) Entgegenhaltungen:
- EP-A- 0 055 642
- EP-A- 0 373 053

## Beschreibung

Die Erfindung betrifft eine Mikrowellen-Streifenleitungsanordnung (Triplate-Leitung) laut Oberbegriff des Hauptanspruches.

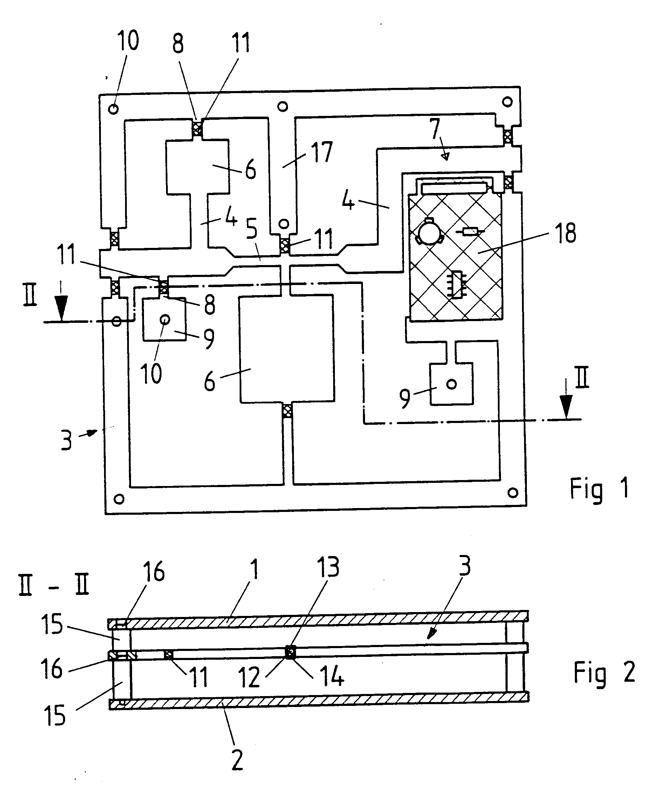

In der sogenannten Triplate-Leitungstechnik ist es bekannt, die Mikrostreifen zwischen den Leiterplatten entweder in einem Dielektrikum einzubetten (Hoffmann: Integrierte Mikrowellenschaltungen, 1983, Bild 1.42. b)) oder mittels dielektrischer Stützen freitragend zwischen den Leiterplatten zu halten (Meinke-Grundlach, Taschenbuch der Hochfrequenztechnik, 1968, S. 263, Abb. 11.5.c; Microwave Stripline Circuits, SCP and Solid State Technology, June 1966, Seite 26, Fig. 2, e) oder Europäische Patentschrift 0 055 642 und EP-A-0 373 053). Es ist auch bekannt, den Mikrostreifenleiter auf einer Trägerplatte aus Isoliermaterial anzubringen und diese Trägerplatte mittels seitlicher Stützen zwischen den Leiterplatten anzuordnen (Suspended-Substrat-Leitung nach Hoffmann, Integrierte Mikrowellenschaltungen, Bild 1.42. c) bzw. Microwave Stripline Circuits, SCP and Solid State Technology, June 1966, Seite 26, Fig. 2 d)). All diesen bekannten Triplate-Leitungen ist der Nachteil gemeinsam, daß sie in der Herstellung relativ teuer und kompliziert sind und vor allem für hohe Leistungen die Verluste relativ groß sind.

Es ist daher Aufgabe der Erfindung, eine im Aufbau einfache, kostengünstig herstellbare Mikrowellen-Streifenleitungsanordnung zu schaffen, die auch bei hohen Leistungen extrem verlustarm ist.

Diese Aufgabe wird ausgehend von eine Mikrowellen-Streifenleitungsanordnung laut Oberbegriff des Hauptanspruches durch dessen kennzeichnende Merkmale gelöst. Vorteilhafte Weiterbildungen insbesondere auch bezüglich eines besonders einfachen und kostengünstigen Verfahrens zur Herstellung einer solchen Mikrowellen-Streifenleitungsanordnung ergeben sich aus den Unteransprüchen.

Eine erfindungsgemäße Mikrowellen-Streifenleitungsanordnung ist extrem verlustarm, die effektive Dielektrizitätskonstante ist im Gegensatz zu den bekannten Triplate- oder Suspended-Substrat-Streifenleitungen nicht frequenzabhängig. Trotzdem kann die erfindungsgemäße Mikrowellen-Streifenleitungsanordnung sehr einfach und kostengünstig im Zuge einer automatisierten Leiterplattenfertigung sehr präzise hergestellt werden. Auf der Trägerplatte aus Isoliermaterial können neben der eigentlichen Mikrostreifenanordnung auch noch weitere Hilfsschaltungen in üblicher gedruckter Schaltungstechnik aufgebaut werden, die in üblicher Weise auch automatisch bestückt werden können, auch zusätzliche Abschirmwände für solche Hilfsschaltungen können auf der Trägerplatte zwischen den Leiterplatten eingebaut werden. Die mit den seitlich abstehenden schmalen Isolierstegen verbundenen Halteabschnitte, an denen die mit den Leiterplatten galvanisch verbundenen leitenden Stützen angreifen, können zusätzlich als elektrische Abschirmung zwischen einzelnen Abschnitten der Mikrowellenschaltung ausgenutzt werden.

Die Erfindung wird im folgenden anhand schematischer Zeichnungen an einem Ausführungsbeispiel näher erläutert.

Fig. 1 zeigt die Draufsicht auf eine erfindungsgemäße Mikrowellen-Streifenleitungsanordnung die gemäß dem Schnittbild nach Fig. 2 durch eine zwischen zwei Leiterplatten 1 und 2 angeordneten Streifenleiteranordnung 3 gebildet ist. Die Mikrowellen-Streifenleitungsanordnung ist in dem gezeigten Ausführungsbeispiel als Hochfrequenzfilter für hohe Leistungen im MHz-Bereich ausgelegt, wie sie beispielsweise in VHF-/UHF-Sendeanlagen benutzt wird. Die Streifenleiteranordnung 3 besteht aus einzelnen Streifenleiterabschnitten 4, die mit zusätzlichen Leitungsbauelementen wie schmalen Induktivitäten 5, großflächigen Kondensatorplatten 6 oder Kopplern 7 zusammenwirken. Sowohl die Streifenleiter als auch diese zusätzlichen Leitungsbauelemente sind in üblicher Leiterplatten-Fertigungstechnik aus einer Trägerplatte aus Isoliermaterial geformt, d.h. aus einer für die Leiterplattenfertigung üblichen Trägerplatte aus Epoxidharz, Polyimid, Teflon, glasfaserverstärktem Kunststoff oder auch aus einem Isoliermaterial, wie es in der Dünnschicht-Schaltungstechnik üblich ist, wird durch Fräsen die gewünschte Form der Leiterstreifen 4 und der zusätzlichen Leitungsbauelemente 5, 6 und 7 ausgefräst. Zusätzlich werden an ausgewählten Stellen dieser Leiterstreifen 4 und der Leitungsbauelemente 5 bis 7 schmale seitlich in der Ebene der Trägerplatte abstehende Stege 8 aus der Trägerplatte ausgefräst, die am einen Ende in den Streifenleiter 4 bzw. die Bauelemente 5 bis 7 übergehen und die am äußeren Ende in einen Halteabschnitt 9 übergehen, der in gleicher Weise aus der Trägerplatte ausgefräst wird und in welchen ein Befestigungsloch 10 gebohrt ist. Nach dem Bohren der Befestigungslöcher 10 und dem Ausfräsen der Streifenleiter, Stege und Leitungsbauelemente wird die gesamte Mikrowellenschaltung in bekannter Galvanisierungstechnik mit einer Metallschicht überzogen, wobei nur Teilabschnitte 11 der Stege 8 frei bleiben. Es ist ausreichend, im Sinne des Schnittbildes nach Fig. 2 nur auf der Ober- und Unterseite des Kernes 12 aus Isoliermaterial einen Metallüberzug 13 bzw. 14 aufzubringen, vorzugsweise wird jedoch der gesamte Kern 12 allseitig, also auch an den Seitenflächen mit einer Metallschicht überzogen. Es ist dafür zu sorgen, daß das zwischen den Leiterplatten 1 und 2 verlaufende elektrische Feld möglichst nicht durch den Isoliermaterialkern 12 verläuft, sondern dieser Isoliermaterialkern durch einen Metallüberzug abgeschirmt ist, damit die dielektrischen Verluste so gering wie möglich bleiben. Es ist auch denkbar, nur auf der Oberseite und einer Seitenfläche einen Metallüberzug vorzusehen, der dieser Forderung genügt. Auch die Halteabschnitte 9 und die Bohrlöcher 10 werden vorzugsweise metallisiert.

Die so kostengünstig in üblicher Leiterplatten-Fertigungstechnik hergestellte Mikrowellenschaltung wird dann über Stützen 15 zwischen die Leiterplatten 1, 2 eingebaut, die Stützen 15 bestehen vorzugsweise aus Metall, in dem gezeigten Ausführungsbeispiel sind sie über Noppenabschnitte 16 von beiden Seiten in die Befestigungsbohrungen 10 und in entsprechende Passbohrungen in den Leiterplatten 1, 2 eingesetzt, die beiden Leiterplatten 1, 2 sind durch nicht dargestellte Schrauben miteinander verspannt. Die gesamte Mikrowellenschaltung wird also nur über mehrere über die Schaltung verteilte schmale Isoliermaterial-Stege 11 an den Stützen 15 mechanisch abgestützt, die schmalen Stege 11 sind extrem verlustarm und die gesamte Schaltung ist daher besonders für hohe Leistungen geeignet. Die Halteabschnitte 9 können gleichzeitig auch als Abschirmung zwischen benachbarten Schaltungsabschnitten dienen, wie dies durch den länglichen und parallel zu einem der Streifenleiter 4 verlaufenden Halteabschnitt 17, der über zwei Stützen zwischen den Leiterplatten 1, 2 gehalten ist, dargestellt ist und der zusammen mit den leitenden Stützen 15 als Abschirmung zwischen zwei gegenüberliegenden Streifenleitungen wirkt.

Die für hohe Leistung vorgesehene Mikrowellenschaltung kann auch unmittelbar mit elektrischen Hilfsschaltungen kombiniert werden, d.h. auf der gleichen Trägerplatte aus Isoliermaterial, aus welcher die Streifenleiter und Leitungsbauelemente durch Fräsen ausgeformt werden, kann eine elektrische Hilfsschaltung 18 in üblicher gedruckte Schaltungstechnik aufgebaut werden und zwar im gleichen Arbeitsgang wie die Mikrowellenschaltung. In dem gezeigten Ausführungsbeispiel ist diese Hilfsschaltung 18 über einen Leitungskoppler 7, der wieder in Streifenleitungstechnik gemäß der Erfindung aufgebaut ist, mit der übrigen Mikrowellenschaltung verbunden. Diese Hilfsschaltung 18 kann für sich in bekannter Abschirmtechnik durch einen Abschirmrahmen und gegebenenfalls durch einen zusätzlichen Abschirmdeckel von der übrigen Mikrowellenschaltung abgeschirmt sein.

## Patentansprüche

1. Mikrowellen-Streifenleitungsanordnung (Triplate-Leitung) bestehend aus zwei parallelen Leiterplatten (1,2) und einer parallel zu und zwischen diesen angeordneten Mikrostreifenanordnung (3,4,5,6,7), die mittels Stützen (15) zwischen den Leiterplatten (1,2) fixiert ist, dadurch **gekennzeichnet** daß die Mikrostreifenanordnung (3,4,5,6,7) aus einem Kern (12) aus Isoliermaterial besteht, der aus einer Trägerplatte aus Isoliermaterial herausgearbeitet ist und der an mindestens zwei Seiten mit einer Metallschicht (13,14) überzogen ist, und diese Mikrostreifenanordnung (3,4,5,6,7) schmale, seitlich in der Ebene der Mikrostreifenanordnung abstehende Isolierstege (8,11) aufweist, die ebenfalls aus der Trägerplatte herausgearbeitet sind und an denen die Stützen (15) angreifen.

2. Anordnung nach Anspruch 1, dadurch **gekennzeichnet,** daß die seitlich abstehenden schmalen Stege (8,11) in ebenfalls aus der Trägerplatte aus Isoliermaterial geformte Halteabschnitte (9,17) übergehen, die wiederum mindestens auf zwei Seiten mit einer Metallschicht überzogen sind und an denen die Stützen (15) angreifen.

3. Anordnung nach Anspruch 2, dadurch **gekennzeichnet**, daß die Halteabschnitte als im Abstand parallel zu mindestens einem der Streifenleiter (4) der Mikrostreifenanordnung (3) angeordnete Streifen (17) ausgebildet sind.

4. Anordnung nach einem der vorhergehenden Ansprüche, dadurch **gekennzeichnet,** daß die Stützen (15) aus leitendem Material bestehen und mit der Metallschicht der Halteabschnitte (9,10) und den Leiterplatten (1,2) galvanisch verbunden sind.

5. Anordnung nach einem der vorhergehenden Ansprüche, dadurch **gekennzeichnet,** daß in den Halteabschnitten (9,17) Befestigungslöcher (10) ausgebildet sind, in welche die zwischen den Leiterplatten (1,2) angeordneten Stützen (15) eingesetzt sind.

6. Anordnung nach einem oder mehreren der vorhergehenden Ansprüche, dadurch **gekennzeichnet,** daß die Mikrostreifenanordnung (3) aus Mikrostreifenleitern (4) und Leitungsbauelementen (Induktivitäten 5, Kapazitäten 6 oder Koppler 7) besteht und sowohl diese Mikrostreifenleiter (4) als auch die Leitungsbauelemente (5,6,7) aus der Trägerplatte aus Isoliermaterial herausgearbeitet und mindestens an zwei Seiten mit einer Metallschicht (13,14) überzogen sind.

7. Anordnung nach einem der vorhergehenden Ansprüche, dadurch **gekennzeichnet,** daß der Isoliermaterial-Kern (12) der Streifenleiter (4) und/oder der Leitungsbauelemente (5,6,7) allseits mit einer Metallschicht überzogen ist.

8. Anordnung nach einem oder mehreren der vorhergehenden Ansprüche, dadurch **gekennzeichnet,** daß auf einem Teil der Trägerplatte aus Isoliermaterial, aus welcher die Mikrostreifenanordnung (3,4,5,6,7) und die Isolierstege (8,11) herausgearbeitet sind, in bekannter gedruckter Schaltungstechnik eine zusätzliche Hilfsschaltung (18) ausgebildet ist.

9. Verfahren zum Herstellen einer Mikrowellen-Streifenleitungsanordnung nach einem oder mehreren der vorhergehenden Ansprüche, dadurch **gekennzeichnet,** daß aus einer Trägerplatte aus Isoliermaterial, wie sie für gedruckte Schaltungen benutzt wird, in bekannter Leiterplatten-Fertigungstechnik durch Bohren, Fräsen und Galvanisieren die Mikrostreifenanordnung in der gewünschten Form mit ihren seitlich abstehenden Isolierstegen ausgeformt wird, die dann mittels Stützen, die an Halteabschnitten der Isolierstege der Mikrostreifenanordnung angreifen, zwischen zwei Leiterplatten angeordnet wird.

## Claims

1. Microwave stripline arrangement (triplate) consisting of two parallel printed-circuit boards (1,2) and disposed parallel to and between them a microstrip arrangement (3,4,5,6,7) fixed in place between the printed-circuit boards (1,2) by supports (15),
characterised in that the microstrip arrangement (3,4,5,6,7) consists of a core (12) of insulating material which has been machined from an insulant carrier sheet and which is coated on at least two sides with a layer of metal (13,14), and said microstrip arrangement (3,4,5,6,7) incorporates slender barriers (8,11) projecting laterally in the plane of the microstrip arrangement and which have likewise been machined from the carrier sheet and are acted on by the supports (15).

2. Arrangement according to claim 1, characterised in that the laterally projecting slender lands (8, 11) merge into holding sections (9,17) likewise formed from the insulant carrier sheet and which in turn are coated with a layer of metal at least on two sides and are acted on by the supports (15).

3. Arrangement according to claim 2, characterised in that the holding sections are in the form of strips (17) spaced parallel to at least one of the strip conductors (4) of the microstrip arrangement (3).

4. Arrangement according to any one of the preceding claims, characterised in that the supports (15) consist of conductive material and are galvanically connected to the metallic layer of the holding sections (9,10) and to the printed circuit-boards (1,2).

5. Arrangement according to any one of the preceding claims, characterised in that in the holding sections (9,17) are formed fixing holes (10) into which the supports (15) arranged between the printed-circuit boards (1,2) are inserted.

6. Arrangement according to any one or more of the preceding claims, characterised in that the microstrip arrangement (3) consists of microstrip conductors (4) and circuit components (inductors 5, capacitors 6 or couplers 7) and both these microstrip conductors (4) and the circuit components (5,6,7) have been machined from the insulant carrier sheet and coated with a layer of metal (13,14) on at least two sides.

7. Arrangement according to any one of the preceding claims, characterised in the insulant core (12) of the strip conductors (4) and/or of the circuit components (5,6,7) is coated on all sides with a layer of metal.

8. Arrangement according to any one or more of the preceding claims, characterised in that an additional auxiliary circuit (18) is formed by conventional printed circuit technology on one part of the insulant carrier sheet from which the microstrip arrangement (3,4,5,6,7) and the barriers (8,11) have been machined.

9. Method for manufacturing a microwave stripline arrangement according to any one or more of the preceding claims, characterised in that conventional pcb production methods, namely drilling, milling and electroplating, are used to fashion the microstrip arrangement in the desired form with its laterally protruding barriers from an insulant carrier sheet of the type used for printed circuits, and said microstrip arrangement is then disposed between two printed-circuit boards by means of supports which act on holding sections of the barriers of the microstrip arrangement.

## Revendications

1. Assemblage de conducteurs à bande pour micro-ondes (Triplate-Leitung) constitué par deux cartes de circuit imprimé parallèles (1, 2) et un assemblage de micro-bandes (3, 4, 5, 6, 7) parallèle à ces cartes et disposé entre elles, qui est fixé au moyen d'appuis (15) entre les cartes de circuit imprimé (1, 2), caractérisé en ce que l'assemblage de micro-bandes (3, 4, 5, 6, 7) est constitué par un noyau (12) en matière isolante, qui est usiné à partir d'une plaque de support en matière isolante et qui est revêtu sur au moins deux côtés d'une couche métallique (13, 14), et cet assemblage de micro-bandes (3, 4, 5, 6, 7) comporte d'étroites barrettes isolantes (8, 11) s'écartant latéralement dans le plan de l'assemblage de micro-bandes, et qui sont également usinées à partir de la plaque de support et sur lesquelles viennent en prise les appuis (15).

2. Assemblage selon la revendication 1, caractérisé en ce que les étroites arêtes (8,11) s'écartant latéralement se transforment en tronçons de maintien (9,17) formés également en matière isolante à partir de la plaque de support et qui à leur tour sont revêtues au moins sur deux côtés d'une couche métallique et contre lesquelles viennent en prise les appuis (15).

3. Assemblage selon la revendication 2, caractérisé en ce que les tronçons de maintien revêtent la forme de bandes (17) disposées parallèlement à une certaine distance d'au moins un des conducteurs en bandes (4) de l'assemblage de micro-bandes (3).

4. Assemblage selon une des précédentes revendications, caractérisé en ce que les appuis (15) sont constitués d'une matière conductrice et sont reliés galvaniquement à la couche métallique des tronçons de maintien (9, 10) et avec les cartes de circuit imprimé (1, 2).

5. Assemblage selon une des précédentes revendications, caractérisé en ce que dans les tronçons de maintien (9, 17) sont pratiqués des trous de fixation (10), dans lesquels sont mis en place les appuis (15) disposés entre les cartes de circuit imprimé (1, 2).

6. Assemblage selon une ou plusieurs des revendications précédentes, caractérisé en ce que l'assemblage de micro-bandes (3) est constitué par des conducteurs micro-bandes (4) et des éléments constitutifs de conduction (inductance 5, capacité 6 ou coupleur 7) et qu'ainsi ces conducteurs micro-bandes (4) comme également les éléments constitutifs ce conduction (5, 6, 7) sont usinés à partir de la plaque de support en matière isolante et sont revêtus au moins sur deux côtés d'une couche métallique (13, 14).

7. Assemblage selon une des précédentes revendications, caractérisé en ce que le noyau en matière isolante (12) des conducteurs en bande (4) et/ou des éléments constitutifs de conduction (5, 6, 7) est revêtu de tous côtés d'une couche métallique.

8. Assemblage selon une ou plusieurs des revendications précédentes, caractérisé en ce que sur une partie de la plaque de support en matière isolante, à partir de laquelle sont usinés l'assemblage de micro-bandes (3, 4, 5, 6, 7) et les barrettes isolantes (8, 11), un circuit auxiliaire supplémentaire (18) est réalisé selon la technique connue des circuits imprimés.

9. Procédé pour fabriquer un assemblage de conducteurs en bande pour micro-ondes selon une ou plusieurs des précédentes revendications, procédé caractérisé en ce qu'à partir d'une plaque de support en matière isolante telle que celle utilisée pour des circuits imprimés, l'assemblage de micro-bandes est réalisé selon la forme désirée avec ses barrettes isolantes s'écartant latéralement selon la technique connue de fabrication des cartes de circuit imprimé par forage, fraisage et galvanisation, et est ensuite disposé au moyen d'appuis, qui viennent en prise contre les tronçons de maintien des barrettes isolantes de l-sssemblage de micro-bandes, sont disposé entre deux cartes de circuit imprimé.
